# EUROPEAN PATENT SPECIFICATION

(11) **EP 3 261 126 B1**
(45) Date of publication and mention of the grant of the patent: **15.01.2025**
(21) Application number: 16175840.4
(22) Date of filing: 22.06.2016
(51) Int. Cl.: H01L 29/78, H01L 21/761, H01L 29/10

(54) **HIGH-VOLTAGE SEMICONDUCTOR DEVICE AND METHOD FOR MANUFACTURING THE SAME**
HOCHSPANNUNGSHALBLEITERBAUELEMENT UND VERFAHREN ZUR HERSTELLUNG DAVON
DISPOSITIF SEMI-CONDUCTEUR À HAUTE TENSION ET SON PROCÉDÉ DE FABRICATION

(43) Date of publication of application: 27.12.2017
(73) Proprietor: Vanguard International Semiconductor Corporation, 30077 Hsinchu (TW)
(72) Inventor: Chin, Yu-Lung, 710 Tainan City (TW); Lin, Shin-Cheng, 709 Tainan City (TW); Lin, Wen-Hsin, 302 Jhubei City (TW); Wu, Cheng-Tsung, 106 Taipei City (TW)
(74) Representative: Habermann, Hruschka & Schnabel

(56) References cited:
- US-A1- 2011 220 995
- US-A1- 2013 270 606
- US-A1- 2013 307 072
- US-A1- 2015 041 890

## Description

### Field of the Disclosure

The present disclosure relates to a semiconductor technology, and in particular, it relates to a high-voltage semiconductor device that is capable of reducing or eliminating body effect.

### Description of the Related Art

High-voltage semiconductor technology is applied to integrated circuits (ICs) with high voltage and high power. Traditional high-voltage semiconductor devices, such as lateral diffused MOSFETs (LDMOSFETs), are mainly used for devices with at least 18 volts or higher. The advantages of high-voltage device technology include cost effectiveness and process compatibility, and thus high-voltage device technology has been widely used in display driver IC devices, and power supply devices, and power management, communications, autotronics, and industrial control fields, etc.

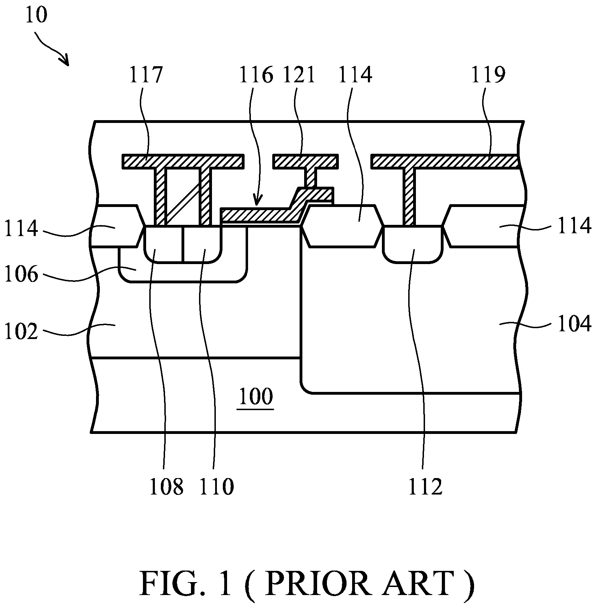

FIG. 1 is a cross section of a conventional n-type LDMOSFET. The n-type LDMOSFET 10 includes a p-type semiconductor substrate 200 and a p-type epitaxial layer 102 thereon. A gate structure 116 and a field oxide layer 114 are on the p-type epitaxial layer 102. Moreover, a p-type body region 106 and an n-type drift region 104 are respectively in the p-type epitaxial layer 102 on both sides of the gate structure 116. The n-type drift region 104 further extends into the underlying p-type semiconductor substrate 200. A p-type contact region 108 and an adjacent n-type contact region 110 (or both referred to as a source region) are in the body region 106 and an n-type contact region 112 (or referred to as a drain region) is in the drift region 104. Moreover, a source electrode 117 is electrically connected to the p-type contact region 108 and the n-type contact region 110. A drain electrode 119 is electrically connected to the n-type contact region 112. A gate electrode 121 is electrically connected to the gate structure 116.

In such an n-type LDMOSFET 10, however, the source region is electrically connected to the underlying p-type semiconductor substrate 200 via the body region 106. Therefore, the body effect is induced to change the threshold voltage of the transistor 10 when the source region is coupled to an internal circuit or resistor. As a result, the driving current of the transistor 10 is reduced with increasing the voltage applied to the source region, and thus the performance of the transistor 10 is reduced.

US 2011/0220995 A1 relates to a semiconductor device that, in an embodiment, is in the form of a high voltage MOS (HVMOS) device. The device includes a semiconductor substrate and a gate structure formed on the semiconductor substrate. The gate structure includes a gate dielectric which has a first portion with a first thickness and a second portion with a second thickness. The second thickness is greater than the first thickness. A gate electrode is disposed on the first and second portion. In an embodiment, a drift region underlies the second portion of the gate dielectric. A method of fabricating the same is also provided.

US 2015/041890 A1 relates to semiconductor structures. Each semiconductor structure can comprise a substrate and at least one laterally double-diffused metal oxide semiconductor field effect transistor (LDMOSFET) on the substrate. Each LDMOSFET can have a fully-depleted deep drain drift region (i.e., a fully depleted deep ballast resistor region) for providing a relatively high blocking voltage. Different configurations for the drain drift regions are disclosed and these different configurations can also vary as a function of the conductivity type of the LDMOSFET. Additionally, each semiconductor structure can comprise an isolation band positioned below the LDMOSFET and an isolation well positioned laterally around the LDMOSFET and extending vertically to the isolation band such that the LDMOSFET is electrically isolated from both a lower portion of the substrate and any adjacent devices on the substrate.

US 2013/270606 A1 relates to a device which includes a semiconductor substrate having a first conductivity type, a device isolating region in the semiconductor substrate, defining an active area, and having a second conductivity type, a body region in the active area and having the first conductivity type, and a drain region in the active area and spaced from the body region to define a conduction path of the device, the drain region having the second conductivity type. The device isolating region and the body region are spaced from one another to establish a first breakdown voltage lower than a second breakdown voltage in the conduction path.

US 2013/307072 A1 relates to a double diffused metal oxide semiconductor (DMOS) device and a manufacturing method thereof. The DMOS device is formed in a first conductive type substrate, and includes a second conductive type high voltage well, a field oxide region, a gate, a second conductive type source, a second conductive type drain, a first conductive type body region, and a first conductive type deep well. The deep well is formed beneath and adjacent to the high voltage well in a vertical direction. The deep well and the high voltage well are defined by a same lithography process step.

Therefore, there is a need to develop a high-voltage semiconductor device and a method for manufacturing the same that are capable of addressing or mitigating the problems described above.

### SUMMARY

According to the invention a high-voltage semiconductor device having the features of claim 1 is provided. Further, the invention provides a method for fabricating a high-voltage semiconductor device having the features of claim 3.

### BRIEF DESCRIPTION OF THE DRAWINGS

The present disclosure can be further understood by reading the subsequent detailed description and examples with references made to the accompanying drawings, wherein:
FIG. 1 is a cross section of a conventional n-type LDMOSFET.
FIGS. 2A to 2F are cross sections of a method for fabricating a high-voltage semiconductor device given as illustrative examples.
FIGS. 3A, 3B and 3D are cross sections of various high-voltage semiconductor devices given as illustrative examples and FIG. 3C is a cross section of a high-voltage semiconductor device according to an embodiment of the invention.

### DETAILED DESCRIPTION

The following description is of the best-contemplated mode of carrying out the disclosure. This description is made for the purpose of illustrating the general principles of the disclosure and should not be taken in a limiting sense. These are, of course, merely examples and are not intended to be limited. In addition, the disclosure may repeat reference numerals and/or letters in the various examples. This repetition is for the purpose of simplicity and clarity and does not in itself dictate a relationship between the various embodiments and/or configurations discussed.

An exemplary embodiment of the present disclosure provides a high-voltage semiconductor device, such as an LDMOSFET, which utilizes a doping region having a conductivity type different from that of the body region to isolate the body region from the substrate that has the same conductivity type as that of the body region, thereby reduce or eliminate the body effect.

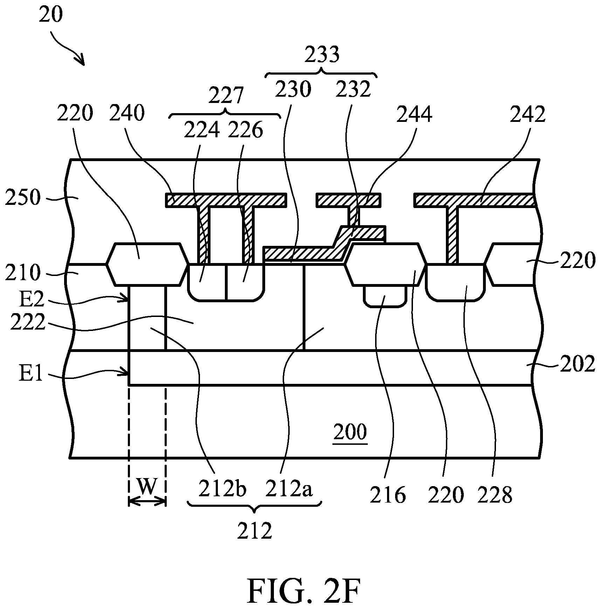

Refer to FIG. 2F, which is a cross section of an illustrative example of a high-voltage semiconductor device 20. In the example, the high-voltage semiconductor device 20 may be an LDMOSFET. The high-voltage semiconductor device 20 includes a semiconductor substrate 200, such as a silicon substrate, a SiGe substrate, a bulk semiconductor substrate, a compound semiconductor substrate, a silicon-on-insulator (SOI) substrate, or another well-known semiconductor substrate, having a first conductivity type.

Moreover, the semiconductor substrate 200 includes a first doping region 202 (such as a high-voltage well region) therein. The first doping region 202 is adjacent to the upper surface of the semiconductor substrate 200. The first doping region 202 has a conductivity type different from the first conductivity type. For example, the first conductivity type is p-type and the second conductivity type is n-type. In some embodiments, the first conductivity type is n-type and the second conductivity type is p-type.

In the illustrative example, the high-voltage semiconductor device 20 further includes an epitaxial layer 210 that is formed on the semiconductor substrate 200 and has the first conductivity type. The epitaxial layer 210 includes a plurality of field insulating layers 220 that serves as an isolation structure. In one embodiment, the field insulating layer 220 is a field oxide. In one example, the field insulating layer 220 includes a local oxidation of silicon (LOCOS) structure. In some embodiments, the field insulating layer 220 includes a shallow trench isolation (STI) structure.

In the illustrative example, the high-voltage semiconductor device 20 further includes a body region 222 having the first conductivity type and second and third doping regions 212a and 212b having the second conductivity type. The body region 222 is in the epitaxial layer 210 over the first doping region 202 and extends from the upper surface of the epitaxial layer 210 to the lower surface thereof, so that the bottom of the body region 22 may adjoin to the first doping region 202. Moreover, the second and third doping regions 212a and 212b are in the epitaxial layer 210 on both opposite sides of the body region 222, respectively, to adjoin the body region 222. In the illustrative example, the second and third doping regions 212a and 212b are disposed over the first doping region 202 and extend from the upper surface of the epitaxial layer 210 to the lower surface thereof, so that the bottom of the second and third doping regions 212a and 212b may adjoin to the first doping region 202. In one embodiment, an exterior edge E2 of the third doping region 212b is aligned with a corresponding exterior edge E1 of the first doping region 202. Moreover, the third doping region 212b has a width W in a range of about 1µm to 8µm.

According to the invention, the first doping region 202 has the same doping concentration as that of the second and third doping regions 212a and 212b. In this case, the first doping region 202 and the second and third doping regions 212a and 212b are high-voltage well regions. Moreover, the second and third doping regions 212a and 212b may be formed by separating a high-voltage well region via the body region 222 or be individual high-voltage well regions formed in the epitaxial layer 210. According to the invention, the high-voltage well region has a doping concentration in a range of about 1.0 × 10¹⁵ to 1.0 × 10¹⁶ ions/cm³. In different examples not being part of the invention, the first doping region 202 has a doping concentration that is the same as that of the second doping region 212a and different from that of the third doping region 212b. In these cases, the first doping region 202 and the second doping region 212a are high-voltage well regions and the third doping region 212b is a well region. The well region (i.e., the third doping region 212b) has a doping concentration greater than that of the high-voltage well region (i.e., the first doping region 202 or the second doping region 212a). Namely, the second and third doping regions 212a and 212b may be formed by separating a high-voltage well region via the body region 222 or be a high-voltage well region and a well region that are respectively formed in epitaxial layer 210. In one example, the high-voltage well region has a doping concentration in a range of about 1.0 × 10¹⁵ to 1.0 × 10¹⁶ ions/cm³, and the well region has a doping concentration in a range of about 1.0 × 10¹⁶ to 1.0 × 10¹⁷ ions/cm³. In the example, the first doping region 202, the second doping region 212a, and the third doping region 212b serve as a drift region of the LDMOSFET.

According to the invention, the high-voltage semiconductor device 20 further includes a source region 227, a drain region 228, and a gate structure 233. The source region 227 and the drain region 228 are respectively disposed in the body region 222 and the second doping region 212a. The source region 227 is formed of a doping region 226 having the second conductivity type and a doping region (which serves as a body contact region) 224 having the first conductivity type. Moreover, the drain region 228 is merely formed of a doping region having the second conductivity type. Furthermore, the gate structure 23 is disposed on the epitaxial layer 210 and covers a portion of the field insulating layer 220, in which this field insulating layer 220 is formed in the second doping region 212a between the source region 227 and the drain region 228. The gate structure 233 typically includes a gate dielectric layer 230 and a gate layer 232 on the gate dielectric layer 230.

According to the invention, the high-voltage semiconductor device 20 may include a field reduction region 216 having the first conductivity type that is disposed in the second doping region 212a below the field insulating layer 220 under the gate structure 233, so as to reduce surface field. The field reduction region 216 has a doping concentration of about 1.0 × 10¹⁷ ions/cm³.

The high-voltage semiconductor device 20 further includes an interlayer dielectric (ILD) layer 250. Interconnect structures 240, 242, and 244 are in the ILD layer 250. The interconnect structure 240 is electrically connected to the source region 227 to serve as a source electrode, the interconnect structure 242 is electrically connected to the drain region 228 to serve as a drain electrode, and the interconnect structure 244 is electrically connected to the gate structure 233 to serve as a gate electrode.

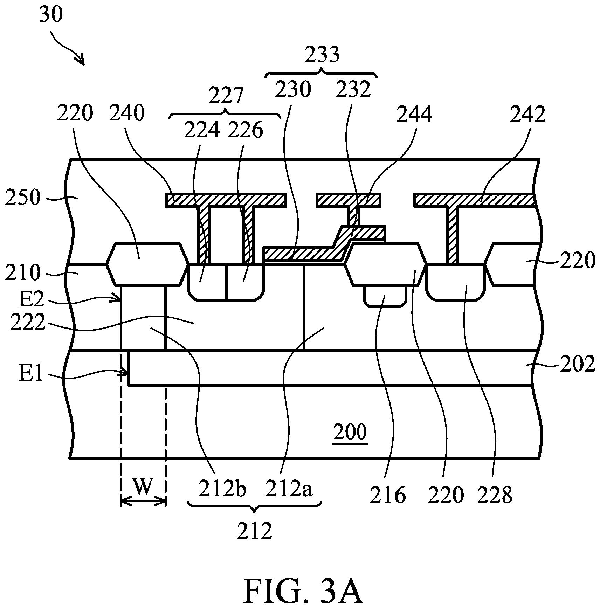

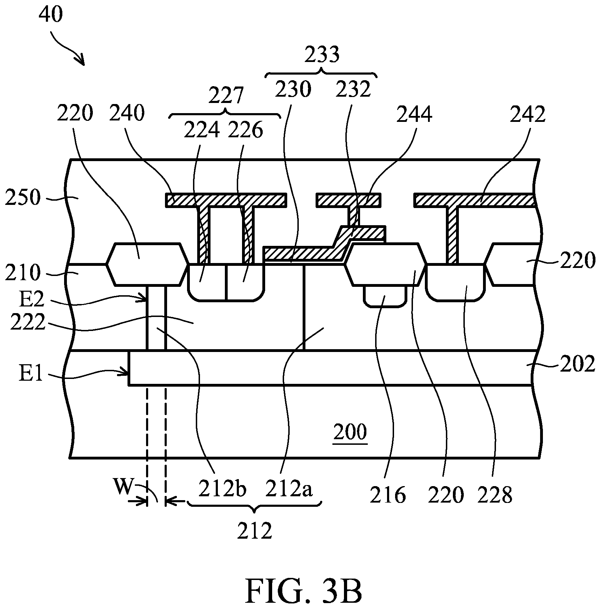

Refer to FIGS. 3A and 3B, which are cross sections of high-voltage semiconductor devices 30 and 40, respectively, according to illustrative examples. Elements in FIGS. 3A and 3B that are the same as or similar to those in FIG. 2F are not described again, for brevity. In FIG. 3A, the high-voltage semiconductor device 30 has a structure that is similar to that of the high-voltage semiconductor device 20 (shown in FIG. 2F). The difference is that the exterior edge E2 of the third doping region 212b in the high-voltage semiconductor device 30 is not aligned with the corresponding exterior edge E1 of the first doping region 212a. For example, the exterior edge E2 laterally extends beyond the exterior edge E1.

In FIG. 3B, the high-voltage semiconductor device 40 has a structure that is similar to that of the high-voltage semiconductor device 20 (shown in FIG. 2F). The difference is that the exterior edge E2 of the third doping region 212b in the high-voltage semiconductor device 40 is not aligned with the corresponding exterior edge E1 of the first doping region 212a. For example, the exterior edge E1 laterally extends beyond the exterior edge E2.

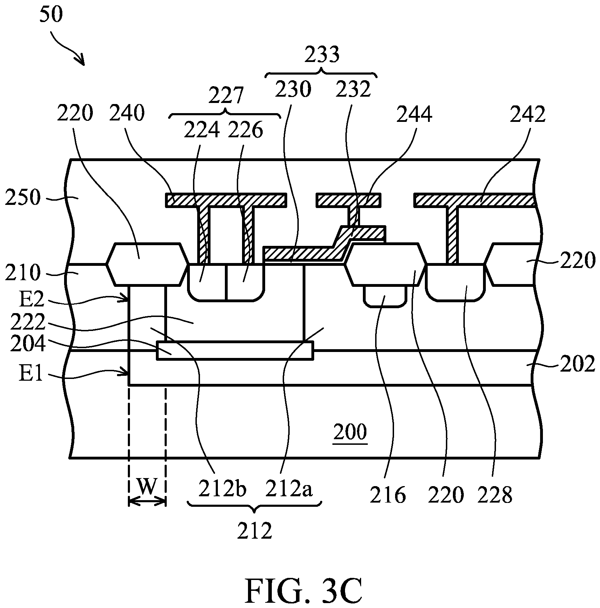

Refer to FIG. 3C, which is a cross section of a high-voltage semiconductor device 50 according to an embodiment of the present disclosure. Elements in FIG. 3C that are the same as or similar to those in FIG. 2F are not described again, for brevity. In the embodiment, the high-voltage semiconductor device 50 has a structure that is similar to that of the high-voltage semiconductor device 20 (shown in FIG. 2F). The difference is that the high-voltage semiconductor device 50 further includes a buried layer 204 having the second conductivity type that is in first doping region 202 below the body region 222, so that the bottom of the body region 222 adjoins the upper surface of the buried layer 204. Moreover, the buried layer 204 has a doping concentration of about 1.0 × 10¹⁸ ions/cm³. In the embodiment, the second doping region 212a and the third doping region 212b are high-voltage well regions or a high-voltage well region and a well region, respectively. In one example, the second conductivity type is n-type and the buried layer 204 is an n⁺ buried layer (NBL).

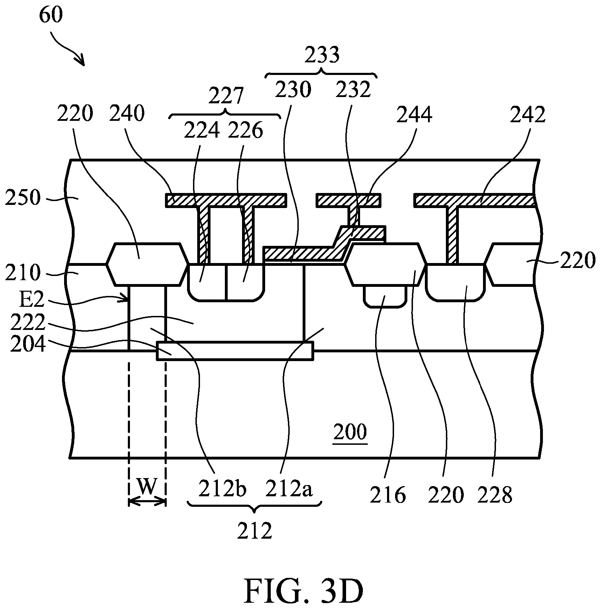

Refer to FIG. 3D, which is a cross section of a high-voltage semiconductor device 60 according to an illustrative example. Elements in FIG. 3D that are the same as or similar to those in FIG. 2F are not described again, for brevity. The high-voltage semiconductor device 60 has a structure that is similar to that of the high-voltage semiconductor device 20 (shown in FIG. 2F). The difference is that the high-voltage semiconductor device 60 utilizes a buried layer 204 having the second conductivity type that is disposed below the body region 222 to replace the first doping region 202 in the high-voltage semiconductor device 20, so that the bottom of the body region 222 adjoins the upper surface of the buried layer 204. The second doping region 212a and the third doping region 212b are high-voltage well regions or a high-voltage well region and a well region, respectively.

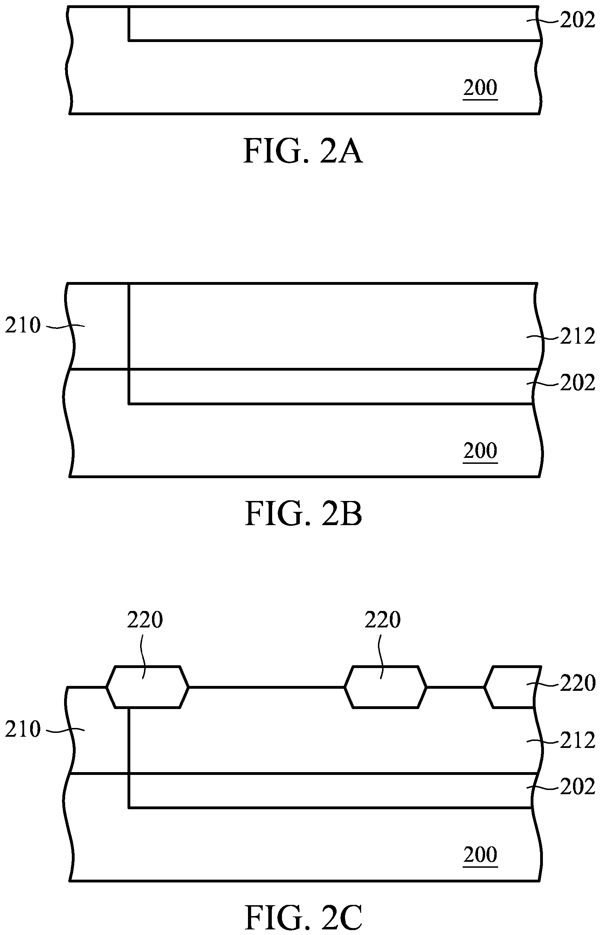

Next, refer to FIGS. 2A to 2F, which are cross sections of a method for fabricating a high-voltage semiconductor device 20 according to illustrative examples. In FIG. 2A, a semiconductor substrate 200 having a first conductivity type is provided. The semiconductor substrate 200 may be a silicon substrate, a SiGe substrate, a bulk semiconductor substrate, a compound semiconductor substrate, an SOI substrate, or another well-known semiconductor substrate.

Next, a first doping region 202, such as a high-voltage well region, may be formed in the semiconductor substrate 200 by an ion implantation process and a thermal process. The first doping region 202 is adjacent to the upper surface of the semiconductor substrate 200. The first doping region 202 has a second conductivity type different from the first conductivity type. For example, the first conductivity type is p-type and the second conductivity type is n-type. The first conductivity type could be n-type and the second conductivity type could be p-type.

Next, Refer to FIG. 2B, an epitaxial layer 210 having the first conductivity type is formed on the semiconductor substrate 200 by an epitaxial growth process. Next, a doping region having the second conductivity type, such as a high-voltage well region 212, may be formed in the epitaxial layer 210 by an ion implantation process and a thermal process. The high-voltage well region 212 and the first doping region 202 have a doping concentration in a range of about 1.0 × 10¹⁵ to 1.0 × 10¹⁶ ions/cm³.

Next, refer to FIG. 2C, field insulating layers 220 serving as isolation structures are formed in the epitaxial layer 210, in which at least one of the field insulating layers 220 is formed in the high-voltage well region 212. The field insulating layer 220 could include a LOCOS structure or an STI structure. The high-voltage well region 212 that has the second conductivity type may be formed in the epitaxial layer 210 after the field insulating layers 220 are formed.

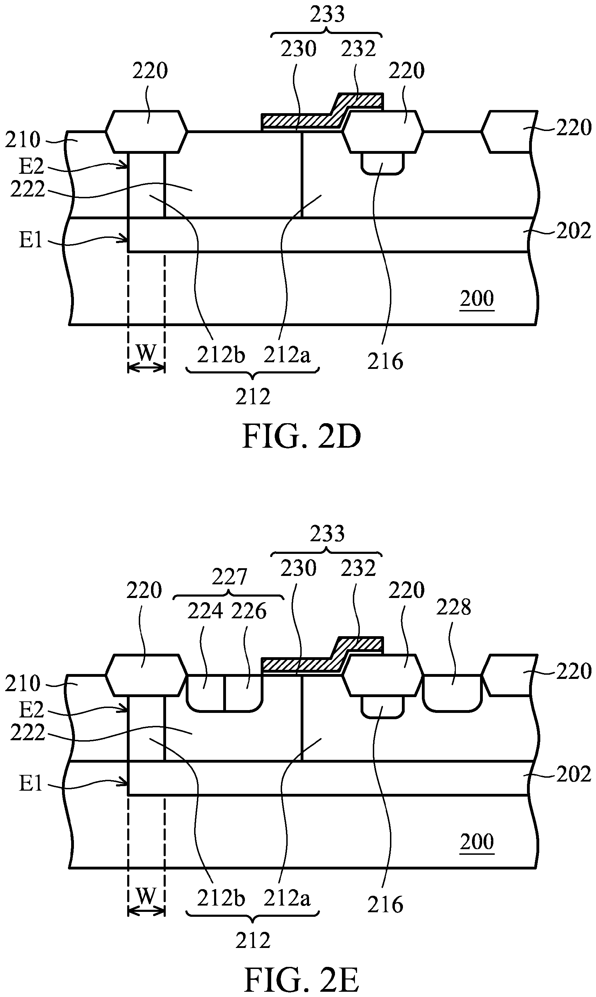

Next, refer to FIG. 2D, a body region 222 having the first conductivity type may be formed in the high-voltage well region 212 of the epitaxial layer 210 by an ion implantation process and a thermal process, thereby dividing the high-voltage well region 212 into a second doping region 212a and a third doping region 212b that have the second conductivity type and the same doping concentration. As shown in FIG. 2D, the body region 222 is formed in the epitaxial layer 210 on the first doping region 202 and extends from the upper surface of the epitaxial layer 210 to the lower surface thereof, so that the bottom of the second and third doping regions 212a and 212b may adjoin to the first doping region 202. An exterior edge E2 of the third doping region 212b is aligned with a corresponding exterior edge E1 of the first doping region 202. Moreover, the third doping region 212b has a width W in a range of about 1µm to 8µm. The second and third doping regions 212a and 212b may be formed by the respective ion implantation processes before or after the body region 222 is formed.

In these cases, the second doping region 212a has a doping concentration that is the same as that of the first doping region 202 and the third doping region 212b. For example, the first doping region 202, the second doping region 212a, and the third doping region 212b are high-voltage well regions, and have a doping concentration in a range of about 1.0 × 10¹⁵ to 1.0 × 10¹⁶ ions/cm³. Alternatively, the second doping region 212a has a doping concentration that is the same as that of the first doping region 202 and is different from that of the third doping region 212b. For example, the first doping region 202 and the second doping region 212a are high-voltage well regions and have a doping concentration in a range of about 1.0 × 10¹⁵ to 1.0 × 10¹⁶ ions/cm³. Moreover, the third doping region 212b is a well region and has a doping concentration in a range of about 1.0 × 10¹⁶ to 1.0 × 10¹⁷ ions/cm³. Namely, the doping concentration of the third doping region 212b is higher than that of the first doping region 202 and the second doping region 212b.

Refer to FIG. 2D, a field reduction region 216 having the first conductivity type that is formed in the second doping region 212a and below the field insulating layer 220, so as to reduce surface field. The field reduction region 216 has a doping concentration of about 1.0 × 10¹⁷ ions/cm³. Next, a gate structure 233 may be formed by a conventional MOS process, in which the gate structure 233 partially covers the field insulating layer 220 above the field reduction region 216. The gate structure 233 typically includes a gate dielectric layer 230 and a gate layer 232 on the gate dielectric layer 230.

Next, refer to FIG. 2E, a source region 227 is formed in the body region 222, and a drain region 228 is formed in the second doping region 212a. The source region 227 is formed of a doping region 226 having the second conductivity type and a doping region (which serves as a body contact region) 224 having the first conductivity type. Moreover, the drain region 228 is merely formed of a doping region having the second conductivity type.

Next, refer to FIG. 2F, a metallization layer is formed on the epitaxial layer 210 by a conventional metallization process to cover the gate structure 233. As a result, the high-voltage semiconductor device 20 is completed. The metallization layer may include an ILD layer 250 and interconnect structures 240, 242, and 244 in the ILD layer 250. The interconnect structure 240 is electrically connected to the source region 227 to serve as a source electrode, the interconnect structure 242 is electrically connected to the drain region 228 to serve as a drain electrode, and the interconnect structure 244 is electrically connected to the gate structure 233 to serve as a gate electrode.

It should be understood that the high-voltage semiconductor devices 30, 40, 50, and 60 respectively shown in FIGS. 3A to 3D can be fabricated by a method that is the same as or similar the method shown in FIGS. 2A to 2F.

According to the foregoing embodiments, doping regions having a conductivity type that is different from that of the body region are formed on both opposite sides and the bottom of the body region. These doping regions constitute a continuous isolation structure to isolate the body region from the substrate in the high-voltage semiconductor device, in which the body region and the substrate have the same conductivity type. Accordingly, when the source region is coupled to an internal circuit or resistor, the body effect can be reduced or eliminated to prevent the driving current from reducing with increasing the voltage applied to the source region. As a result, the performance of the high-voltage semiconductor device can be maintained or increased. Moreover, these doping regions may have the same doping concentration, so that the high-voltage semiconductor device has a stable peak electric field. Additionally, since the high-voltage well region(s) in the high-voltage semiconductor device can be utilized to form the continuous isolation structure, there is no additional manufacturing cost for the isolation structure.

## Claims

1. A high-voltage semiconductor device (50), comprising:
a semiconductor substrate (200) having a first conductivity type;
a first doping region (202) having a second conductivity type in the semiconductor substrate (200);
an epitaxial layer (210) on the semiconductor substrate (200);
a body region (222) having the first conductivity type in the epitaxial layer (210) on the first doping region (202) ;
a second doping region (212a) and a third doping region (212b) that have the second conductivity type, respectively in the epitaxial layer (210) on both opposite sides of the body region (222), so as to adjoin the body region (222);
a source region (227) and a drain region (228) respectively in the body region (222) and the second doping region (212a);
a field insulating layer (220) in the second doping region (212a) between the source region (227) and the drain region (228); and
a gate structure (233) on the epitaxial layer (210) to cover a portion of the field insulating layer (220), **characterized by**
the first doping region (202), the second region (212a) and the third doping region (212b) having a doping concentration in a range of 1.0×10¹⁵ to 1.0×10¹⁶ ions/cm³; and
a buried layer (204) having the second conductivity type in the first doping region (202) below the body region (222), so that the bottom of the body region (222) adjoins the upper surface of the buried layer (204), wherein the buried layer (204) has a doping concentration of 1.0×10¹⁸ ions/cm³.

2. The device as claimed in claim 1, further comprising a field reduction region (216) having the first conductivity type that is in the second doping region (212a) below the field insulating layer (220).

3. A method for fabricating a high-voltage semiconductor device (50), comprising:
providing a semiconductor substrate (200) having a first conductivity type;
forming a first doping region (202) having a second conductivity type in the semiconductor substrate (200);
forming an epitaxial layer (210) on the semiconductor substrate (200);
forming a body region (222) having the first conductivity type in the epitaxial layer (210) and forming a second doping region (212a) and a third doping region (212b) that have the second conductivity type, respectively in the epitaxial layer (210), wherein the body region (222) is on the first doping region (202), and the second and third doping regions (212a;212b) are on both opposite sides of the body region (222), so as to adjoin the body region (222);
forming a field insulating layer (220) in the second doping region (212a);
forming a gate structure (233) on the epitaxial layer (210), wherein the gate structure (233) covers a portion of the field insulating layer (220); and
forming a source region (227) in the body region (222) and forming a drain region (228) in the second doping region (212b) ;
**characterized by**
the first doping region (202), the second region (212a) and the third doping region (212b) having a doping concentration in a range of 1.0×10¹⁵ to 1.0×10¹⁶ ions/cm³; and forming a buried layer (204) having the second conductivity type in the first doping region (202) below the body region (222), so that the bottom of the body region (222) adjoins the upper surface of the buried layer (204), wherein the buried layer (204) has a doping concentration of 1.0×10¹⁸ ions/cm³.

4. The method as claimed in claim 3, further comprising forming a field reduction region (216) having the first conductivity type in the second doping region (212b) below the field insulating layer (220).

## Patentansprüche

1. Hochspannungshalbleiterbauelement (50), aufweisend:
ein Halbleitersubstrat (200) mit einem ersten Leitfähigkeitstyp;
einen ersten Dotierungsbereich (202) mit einem zweiten Leitfähigkeitstyp in dem Halbleitersubstrat (200);
eine Epitaxialschicht (210) auf dem Halbleitersubstrat (200) ;
einen Körperbereich (222) mit dem ersten Leitfähigkeitstyp in der Epitaxialschicht (210) auf dem ersten Dotierungsbereich (202) ;
einen zweiten Dotierungsbereich (212a) und einen dritten Dotierungsbereich (212b), die jeweils den zweiten Leitfähigkeitstyp in der Epitaxialschicht (210) auf beiden gegenüberliegenden Seiten des Körperbereichs (222) aufweisen, so dass sie an den Körperbereich (222) angrenzen;
einen Source-Bereich (227) und einen Drain-Bereich (228) jeweils in dem Körperbereich (222) und dem zweiten Dotierungsbereich (212a);
eine Feldisolationsschicht (220) in dem zweiten Dotierungsbereich (212a) zwischen dem Source-Bereich (227) und dem Drain-Bereich (228); und
eine Gate-Struktur (233) auf der Epitaxialschicht (210), um einen Teil der Feldisolationsschicht (220) zu bedecken, **dadurch gekennzeichnet, dass**
der erste Dotierungsbereich (202), der zweite Dotierungsbereich (212a) und der dritte Dotierungsbereich (212b) eine Dotierungskonzentration in einem Bereich von 1,0 x 10¹⁵ bis 1,0 × 10¹⁶ Ionen/cm³ aufweisen; und
eine vergrabene Schicht (204) mit dem zweiten Leitfähigkeitstyp in dem ersten Dotierungsbereich (202) unterhalb des Körperbereichs (222) vorgesehen ist, so dass der Boden des Körperbereichs (222) an die obere Oberfläche der vergrabenen Schicht (204) angrenzt, wobei die vergrabene Schicht (204) eine Dotierungskonzentration von 1,0 × 10¹⁸ Ionen/cm³ aufweist.

2. Bauelement nach Anspruch 1, des Weiteren aufweisend einen Feldreduktionsbereich (216) mit dem ersten Leitfähigkeitstyp, der sich in dem zweiten Dotierungsbereich (212a) unterhalb der Feldisolationsschicht (220) befindet.

3. Verfahren zur Herstellung eines Hochspannungshalbleiterbauelements (50), aufweisend:
Bereitstellen eines Halbleitersubstrats (200) mit einem ersten Leitfähigkeitstyp;
Ausbilden eines ersten Dotierungsbereichs (202) mit einem zweiten Leitfähigkeitstyp in dem Halbleitersubstrat (200);
Ausbilden einer Epitaxialschicht (210) auf dem Halbleitersubstrat (200);
Ausbilden eines Körperbereichs (222) mit dem ersten Leitfähigkeitstyp in der Epitaxialschicht (210) und Ausbilden eines zweiten Dotierungsbereichs (212a) und eines dritten Dotierungsbereichs (212b), die jeweils den zweiten Leitfähigkeitstyp aufweisen, in der Epitaxialschicht (210), wobei der Körperbereich (222) auf dem ersten Dotierungsbereich (202) liegt und der zweite und der dritte Dotierungsbereich (212a; 212b) auf beiden gegenüberliegenden Seiten des Körperbereichs (222) liegen, so dass sie an den Körperbereich (222) angrenzen;
Ausbilden einer Feldisolationsschicht (220) im zweiten Dotierungsbereich (212a);
Ausbilden einer Gate-Struktur (233) auf der Epitaxialschicht (210), wobei die Gate-Struktur (233) einen Teil der Feldisolationsschicht (220) bedeckt; und
Ausbilden eines Source-Bereichs (227) in dem Körperbereich (222) und Ausbilden eines Drain-Bereichs (228) in dem zweiten Dotierungsbereich (212b);
**dadurch gekennzeichnet, dass**
der erste Dotierungsbereich (202), der zweite Dotierungsbereich (212a) und der dritte Dotierungsbereich (212b) eine Dotierungskonzentration in einem Bereich von 1,0 × 10¹⁵ bis 1,0 × 10¹⁶ Ionen/cm³ aufweisen; und
**gekennzeichnet durch**
Ausbilden einer vergrabenen Schicht (204) mit dem zweiten Leitfähigkeitstyp in dem ersten Dotierungsbereich (202) unterhalb des Körperbereichs (222), so dass der Boden des Körperbereichs (222) an die obere Oberfläche der vergrabenen Schicht (204) angrenzt, wobei die vergrabene Schicht (204) eine Dotierungskonzentration von 1,0×10¹⁸ Ionen/cm³ aufweist.

4. Verfahren nach Anspruch 3, des Weiteren aufweisend Ausbilden eines Feldreduktionsbereich (216) mit dem ersten Leitfähigkeitstyp in dem zweiten Dotierungsbereich (212b) unterhalb der Feldisolationsschicht (220).

## Revendications

1. Dispositif semi-conducteur à haute tension (50) comprenant
un substrat semi-conducteur (200) ayant un premier type de conductivité;
une première région de dopage (202) ayant un deuxième type de conductivité dans le substrat semi-conducteur (200);
une couche épitaxiale (210) sur le substrat semi-conducteur (200);
une région de corps (222) ayant le premier type de conductivité dans la couche épitaxiale (210) sur la première région de dopage (202);
une deuxième région de dopage (212a) et une troisième région de dopage (212b) ayant chacune le deuxième type de conductivité dans la couche épitaxiale (210) sur les deux côtés opposés de la région de corps (222) de manière à être adjacente à la région de corps (222);
une région de source (227) et une région de drain (228) respectivement dans la région de corps (222) et la seconde région de dopage (212a);
une couche d'isolation de champ (220) dans la seconde région de dopage (212a) entre la région de source (227) et la région de drain (228); et
une structure de grille (233) sur la couche épitaxiale (210) pour recouvrir une partie de la couche d'isolation de champ (220),
**caractérisé en ce que**
la première région de dopage (202), la deuxième région de dopage (212a) et la troisième région de dopage (212b) ont une concentration de dopage dans une plage de 1,0 × 10¹⁵ à 1,0 × 10¹⁶ ions/cm³; et
une couche enterrée (204) ayant le second type de conductivité est prévue dans la première région de dopage (202) en dessous de la région de corps (222) de sorte que le fond de la région de corps (222) est adjacent à la surface supérieure de la couche enterrée (204), la couche enterrée (204) ayant une concentration de dopage de 1,0 × 10¹⁸ ions/cm³.

2. Dispositif selon la revendication 1, comprenant en outre une région de réduction de champ (216) ayant le premier type de conductivité, située dans la deuxième région de dopage (212a) en dessous de la couche d'isolation de champ (220).

3. Procédé de fabrication d'un dispositif semi-conducteur à haute tension (50), comprenant:
fournir un substrat semi-conducteur (200) ayant un premier type de conductivité;
former une première région de dopage (202) ayant un second type de conductivité dans le substrat semi-conducteur (200);
former une couche épitaxiale (210) sur le substrat semi-conducteur (200);
former une région de corps (222) ayant le premier type de conductivité dans la couche épitaxiale (210) et former une deuxième région de dopage (212a) et une troisième région de dopage (212b), chacune ayant le deuxième type de conductivité, dans la couche épitaxiale (210), la région de corps (222) étant située sur la première région de dopage (202) et les deuxième et troisième régions de dopage (212a ; 212b) se trouvent sur les deux côtés opposés de la région de corps (222) de manière à être adjacentes à la région de corps (222);
former une couche d'isolation de champ (220) dans la seconde région de dopage (212a);
former une structure de grille (233) sur la couche épitaxiale (210), la structure de grille (233) recouvrant une partie de la couche d'isolation de champ (220); et
former une région de source (227) dans la région de corps (222) et former une région de drain (228) dans la seconde région de dopage (212b);
**caractérisé en ce que**
la première région de dopage (202), la deuxième région de dopage (212a) et la troisième région de dopage (212b) ont une concentration de dopage dans une plage de 1,0 × 10¹⁵ à 1,0 × 10¹⁶ ions/cm³; et
**caractérisé par**
former une couche enterrée (204) ayant le deuxième type de conductivité dans la première région de dopage (202) sous la région de corps (222) de sorte que le fond de la région de corps (222) soit adjacent à la surface supérieure de la couche enterrée (204), la couche enterrée (204) ayant une concentration de dopage de 1,0×10¹⁸ ions/cm³.

4. Procédé selon la revendication 3, comprenant en outre la formation d'une région de réduction de champ (216) ayant le premier type de conductivité dans la seconde région de dopage (212b) en dessous de la couche d'isolation de champ (220).
